# EUROPEAN PATENT SPECIFICATION

(11) **EP 2 502 215 B1**
(45) Date of publication and mention of the grant of the patent: **03.06.2020**
(21) Application number: 10787610.4
(22) Date of filing: 16.11.2010
(51) Int. Cl.: G06F 3/01

(54) **SYSTEMS AND METHODS FOR INCREASING HAPTIC BANDWIDTH IN AN ELECTRONIC DEVICE**
SYSTEME UND VERFAHREN ZUR ERHÖHUNG DER HAPTISCHEN BANDBREITE EINER ELEKTRONISCHEN VORRICHTUNG
SYSTÈMES ET PROCÉDÉS POUR ACCROÎTRE LA LARGEUR DE BANDE HAPTIQUE DANS UN DISPOSITIF ÉLECTRONIQUE

(30) Priority: 17.11.2009 US 262041 P
(43) Date of publication of application: 26.09.2012
(73) Proprietor: Immersion Corporation, San Jose CA 95134 (US)
(72) Inventor: CRUZ-HERNANDEZ, Juan, Manuel, Montreal Québec H3Z 1T1 (CA)
(74) Representative: Phillips & Leigh LLP
(86) International application number: PCT/US2010/056829
(87) International publication number: WO 2011/062895

(56) References cited:
- WO-A1-2004/081776
- WO-A2-2007/117418
- US-A1- 2002 080 112
- US-A1- 2006 290 662
- US-A1- 2007 236 450

## Description

### FIELD OF THE INVENTION

The present disclosure relates generally to systems and methods for increasing haptic bandwidth in an electronic device.

### BACKGROUND

With the increase in popularity of handheld devices, especially mobile phones having touch sensitive surfaces (i.e. touch screens), physical tactile sensations which have traditionally provided by mechanical buttons no longer applies in the realm of this new generation of devices. Tactile confirmation has generally addressed or at the very least substituted the use of programmable mechanical clicks effects by typically using a single actuator, such as a vibrating motor. Such conventional haptic effects include vibrations to indicate an incoming call or text message, or to indicate error conditions.
US 2006/290662 A1 relates to synchronised vibration devices that can provide haptic feedback to a user. A wide variety of actuator types may be employed to provide synchronized vibration, including linear actuators, rotary actuators, rotating eccentric mass actuators, and rocking mass actuators. A controller may send signals to one or more driver circuits for directing operation of the actuators. The controller may provide direction and amplitude control, vibration control, and frequency control to direct the haptic experience. Parameters such as frequency, phase, amplitude, duration, and direction can be programmed or input as different patterns suitable for use in gaming, virtual reality and real-world situations. Input parameters of amplitude, phase and position for a pair of linear actuators may be used to vary force effects and control the direction of vibration.
WO 2007/117418 A2 relates to a handheld gaming machine including one or more actuators for providing vibrational cues or feedback during play of a wagering game to indicate the occurrence of a wagering- game event, such as a change in game rules, an input of a wager, and the like. The positioning of two actuators creates a "stereo haptic" effect, which can be actuated independently to create vibrational cues and feedback that are sensed by different parts of the player's body, for example the left and right hands or by the left and right thighs of a player's lap. The actuators can be vibrated according to respective vibrating profiles.

### SUMMARY

Embodiments of the present invention provide systems and methods for increasing haptic bandwidth in an electronic device. The present invention provides an apparatus as defined in claim 1. The present invention correspondingly provides a method as defined in claim 12 and a computer readable medium as defined in claim 15. Further optional features of the invention are defined in the dependent claims.

These illustrative embodiments are mentioned not to limit or define the invention, but rather to provide examples to aid understanding thereof. Illustrative embodiments are discussed in the Detailed Description, which provides further description of the invention. Advantages offered by various embodiments of this invention may be further understood by examining this specification.

### BRIEF DESCRIPTION OF THE DRAWINGS

The accompanying drawings, which are incorporated into and constitute a part of this specification, illustrate one or more examples of embodiments and, together with the description of example embodiments, serve to explain the principles and implementations of the embodiments.
Figure 1 shows a system for increasing haptic bandwidth in electronic devices according to an embodiment of the present invention;
Figures 2 and 3 illustrate an actuator's response to a pulsing signal at frequencies of 5 and 10 Hz, respectively;
Figure 4 illustrates a block diagram of an electronic device in accordance with an embodiment of the present invention;
Figure 5 illustrates a QWERTY keyboard having haptic areas in accordance with an embodiment of the present invention;
Figure 6 illustrates scheduled activation of multiple actuators in response to interaction of the QWERTY keyboard in Figure 5 in accordance with an embodiment of the present invention;
Figure 7 illustrates a flow chart directed to the method of outputting haptic effects to increase the haptic bandwidth in an electronic device in accordance with an embodiment of the present invention; and
Figure 8 illustrates a flow chart directed to the method of outputting haptic effects to increase the haptic bandwidth in an electronic device in accordance with an embodiment.

### DETAILED DESCRIPTION

Example embodiments are described herein in the context of systems and methods for increasing haptic bandwidth in an electronic device. Those of ordinary skill in the art will realize that the following description is illustrative only and is not intended to be in any way limiting. Other embodiments will readily suggest themselves to such skilled persons having the benefit of this disclosure. Reference will now be made in detail to implementations of example embodiments as illustrated in the accompanying drawings. The same reference indicators will be used throughout the drawings and the following description to refer to the same or like items.

In the interest of clarity, not all of the routine features of the implementations described herein are shown and described. It will, of course, be appreciated that in the development of any such actual implementation, numerous implementation-specific decisions must be made in order to achieve the developer's specific goals, such as compliance with application- and business-related constraints, and that these specific goals will vary from one implementation to another and from one developer to another.

### Illustrative System for Increasing Haptic Bandwidth in an Electronic Device

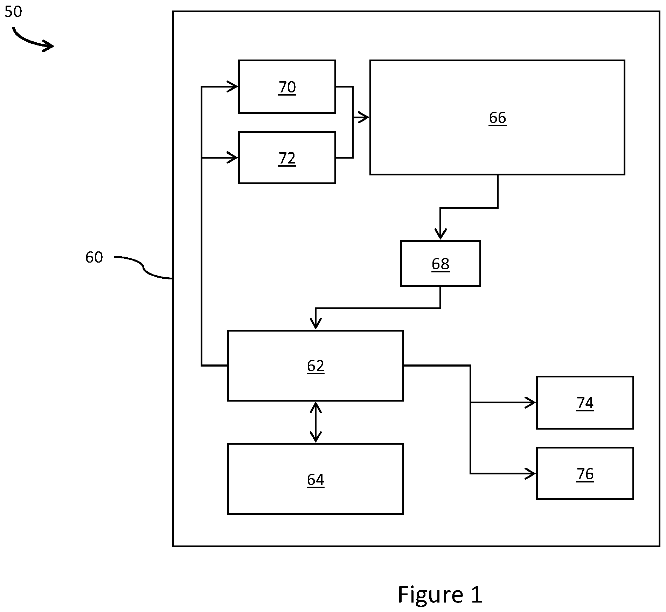

Referring now to Figure 1, Figure 1 shows a system 50 for increasing haptic bandwidth in an electronic device according to one illustrative embodiment of the present invention. In the embodiment shown in Figure 1, a cell phone 60 comprises a touch screen 66 and several actuators 70-76 for outputting various haptic effects to the cell phone 60. In this illustrative embodiment, two of the actuators 70, 72 are piezo-electric actuators and the other two actuators 74, 76 are rotary motors having an eccentric rotating mass (commonly referred to as an "ERM"). In addition to these components, the cell phone 60 also includes a processor 62, a memory 64, a sensor 68.

During ordinary operation, the processor 62 executes software stored in memory 64 and displays graphical user interface (GUI) elements on the touch screen 66. A user interacts with the cell phone 60 by touching the touch screen 66 to select one or more GUI elements or by making gestures on the touch screen 66. The sensor 68 detects the various contacts with the touch screen 66 and provides sensor signals to the processor 62, which interprets the signals based on the position of GUI elements displayed on the touch screen 66 and any detected gestures.

At some time during operation, the processor 62 may determine that one or more haptic effects are to be output to the cell phone 60 based on user inputs or on events occurring within the GUI or other applications executed by the processor 62, such as text messaging software. After determining one or more haptic effects to be output, the processor 62 selects one or more actuators 70-76 to use to output the haptic effects. In the embodiment shown in Figure 1, memory 64 stores parametric information about each of the actuators, including frequency ranges, resonant frequencies, startup and stop times, power consumption, or physical coupling information, such as whether the actuator is coupled to the housing of the cell phone 60, the touch screen 66, or other parts of the cell phone 60, such as physical keys or buttons (not shown). Based on the actuator information, the processor 62 generates actuator signals for the haptic effects, selects the actuator or actuators to output the haptic effects, and transmits the actuator signals to the actuator(s) at the appropriate times to generate the desired haptic effects.

For example, if a user is typing on a virtual keyboard displayed on the touch screen 66, each key "pressed" by the user may result in a haptic effect. In this embodiment, the processor 62 determines that sharp, high-frequency haptic effects are needed for each key press. The processor 62 then determines that the ERM actuators 74, 76 should be used to output the haptic effects. For example, the processor 62 determines that the ERM actuators 74, 76 are capable of generating high-magnitude forces and are coupled to the housing of the cell phone 60 based on stored actuator profiles for each of the actuators 70-76. Further, the processor 62 determines that because key presses may occur in rapid succession, both ERM actuators 74, 76 should be used and should be alternated because the startup and stop characteristics of the ERM actuators 74, 76 may take too long to fully stop a haptic effect before the next haptic effect is to be output, i.e. the individual ERM actuators 74, 76 may have insufficient bandwidth to support haptic effects that occur as rapidly as keystrokes.

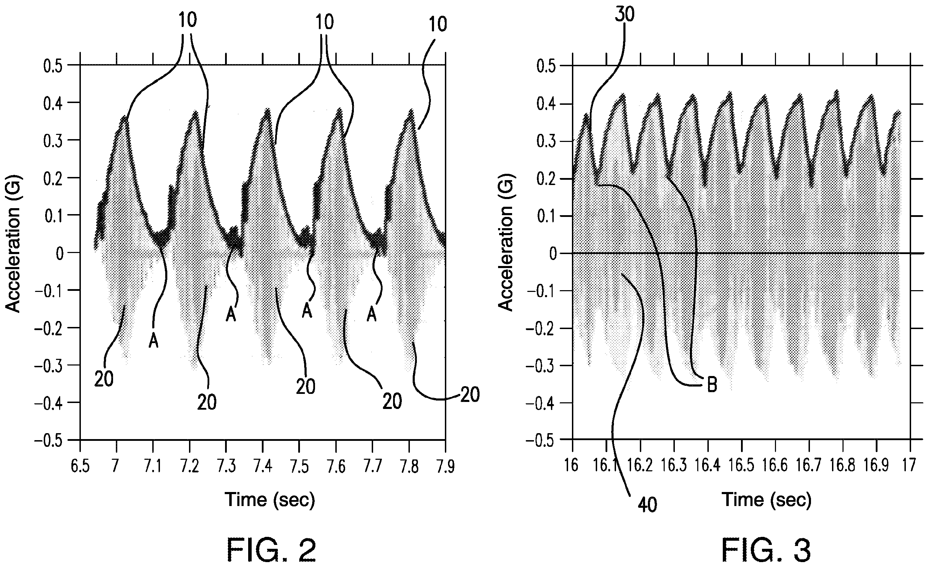

One way of defining the bandwidth of a vibrating motor actuator is the maximum frequency that can be obtained between from an actuator before the pulses output by the actuator begin to feel as mushy, continuous vibration. For example, as shown in Figure 2, the pulses 10 are generated by a single vibrating actuator in response to a non-continuous or pulsed signal 20, whereby the pulsed signal 20 is approximately at 5 Hz. For the 5 Hz pulsing signal, the response or deceleration output by the actuator is such that the actuator is able to vibrate for some time and come to an almost complete stop (Point A) before it is instructed to accelerate again. Figure 3 illustrates the same actuator in which the pulsing signal is at a frequency of 10 Hz. As can be seen in Figure 2, the magnitude of pulse vibrations 30 output by the actuator is not able to approach a zero value before the pulsing signal 40 instructs it to begin accelerating again (see Point B in Figure 2). In other words, the actuator is unable to decelerate to a magnitude where the magnitude of the haptic effect cannot be felt before the actuator begins to accelerate toward the maximum magnitude again. This can lead to "mushy" haptic effects where each effect tends to be hard to distinguish from the next, which tends to degrade the user's experience. Thus, to increase haptic bandwidth, the illustrative system in Figure 1 employs multiple actuators and novel methods of actuating those actuators.

After determining that keyboard presses should be generated by the ERM actuators 74, 76, the processor may determine that additional haptic effects are needed. For example, when the user presses the "send" button, the processor 62 determines that a haptic effect should be output to indicate that the send button was pressed. In this illustrative embodiment, the processor 62 determines that a texture haptic effect should be output in addition to a vibration effect. In such an embodiment, the processor 62 generates the vibration effects by sending signals alternately to one ERM actuator 74 and then the other ERM actuator 76, as will be described in greater detail below.

In addition, the processor 62 generates actuator signals with high frequencies (e.g. >20kHz) and determines that the ERM actuators are already in use, that the ERM actuators are not suitable for generating such high frequencies, and that the piezoelectric actuators 70, 72 are capable of generating the necessary frequencies. Further, the processor 62 determines, based on the stored actuator parameter information, that each piezoelectric actuator 70, 72 is configured to output a haptic effect in only one dimension and that the two piezoelectric actuators 70, 72 are oriented along orthogonal axes. Therefore, in this embodiment, the processor 62 determines that each of the piezoelectric actuators 70, 72 should be actuated to generate the texture effect. Thus, the processor 62 transmits high-frequency actuator signals to each of the piezoelectric actuators 70, 72 to generate a haptic effect to simulate a textured surface on the touch screen 66.

Such an illustrative embodiment provides increased haptic bandwidth by selectively actuating actuators 70-76 based on performance characteristics of the actuators stored within the cell phone's memory 64. Further, because a plurality of different actuators are provided, multiple effects may be output (or played) simultaneously, or may be output with high fidelity despite insufficient performance characteristics of one or more of the actuators 70-76 for the haptic effects to be output. For example, high-magnitude precise vibrations can be output a rate greater than the peak bandwidth of one of the ERM actuators 74, 76 by outputting the vibrations alternately between the two ERM actuators 74, 76.

This illustrative example is given to introduce the reader to the general subject matter discussed herein. The invention is not limited to this example. The following sections describe various additional non-limiting embodiments and examples of systems and methods for increasing haptic bandwidth in an electronic device.

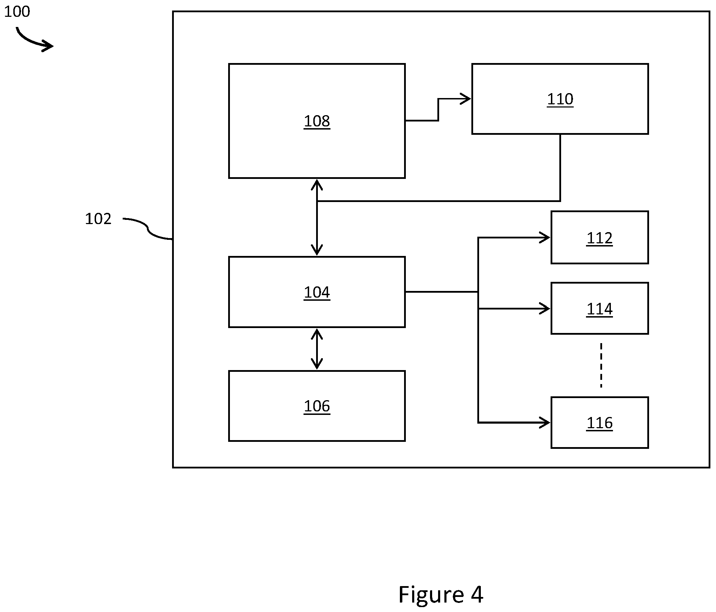

Referring now to Figure 4, Figure 4 illustrates a block diagram of an electronic device in accordance with an embodiment. In particular, Figure 4 illustrates an electronic device 100 having a body or housing 102, a processor 104 within the body 102 and coupled to a memory 106. The processor 104 is able to store information to and retrieve information from the memory 106. Such information may include, but is not limited to, actuator profiles, haptic effect profiles, haptic effect output time sequences, programmed voltages to send to the actuators, game data, software data, etc.

The electronic device 100 is shown with one or more optional touch screens, touch pads or other touch sensitive components 108 coupled to the processor 104. It should be noted that some embodiments of the present invention may not include a touch sensitive component 108. For instance, some embodiments of the present invention may be applied to other types of devices, such as a joystick, rotatable knob, stand-alone kiosk, computer mouse, virtual reality simulation, computer peripheral, smart phone, handheld computer, game peripheral, etc. However, for explanation purposes, the touch sensitive component 108 will be used to describe embodiments of systems and methods for increasing haptic bandwidth in an electronic device.

In addition, as shown in Figure 4, the device 100 includes a sensor 110 coupled to the touch screen 108 and processor 104, whereby the sensor 110 monitors the position, pressure, and/or movement of the user's finger(s), stylus or other input means during interaction with the touch sensitive component 108. The sensor 110 provides sensor signals to the processor 104 to indicate the pressure, position and/or movement of the user's input, whereby the processor 104 running the software program updates the display shown through the touch sensitive component 108 in response thereto. In an embodiment, the touch sensitive component 108 incorporates the sensor 110 therein as an integral component, and thus the sensor 110 is not a separate component. However, for purposes of discussion, the sensor 110 is referred to herein as a separate component.

In addition, the electronic device 100 includes a plurality of actuators 112, 114, 116 within the body. It should be noted that although three actuators are shown in Figure 4, as little as two actuators are contemplated or more than three actuators are also contemplated. In an embodiment, the actuators 112, 114, 116 are all mounted to the body 102 of the device 100 to impart a haptic effect thereto. In an embodiment, one or more of the actuators are mounted to the touch sensitive component 108 or other respective user input device to impart a localized haptic effect thereto. It is contemplated that one or more of the actuators may be mounted to the touch sensitive component 108 or other respective user input device while the remaining actuators are mounted to the body 102 or to one or more physical buttons (not shown). In an embodiment, at least one actuator is suspended within the body 102 and may be configured to impart haptic effects to the touch sensitive component and/or the body 102. The actuator may be designed to utilize a flexible or resilient material to amplify haptic effects produced therefrom. In an embodiment, one or more actuators are part of an external device or peripheral that is externally mounted to the body 102 to output haptic effects thereto.

In the embodiment shown, the actuators 112-116 are configured to output one or more haptic effects upon receiving an input command signal from the processor 104. The input command signal may be from an interaction which may occur between the user and a graphical object within a graphical environment run by a software program, whereby the software program may be run on the local processor or a host computer separate from the electronic device. The interaction may also be user independent in which the user's action does not cause the interaction (e.g. text message received, asteroid hitting the user's vehicle in a game). The interaction may, however, cause a haptic event to occur or may be the product of the user selecting a haptic area, both of which are discussed in more detail below.

The above mentioned actuators can be of various types including, but not limited to, eccentric rotational mass (ERM) actuators, linear resonant actuators (LRA), piezoelectric actuator, voice coil actuator, electro-active polymer (EAP) actuators, memory shape alloys, pager or DC motors, AC motors, moving magnet actuators, E-core actuators, smartgels, electrostatic actuators, electrotactile actuators, etc.

As stated above, the actuators 112-116 output their respective haptic effects in response to one or more haptic events occurring in the graphical environment. The haptic event is referred to herein as any interaction, action, collision, or other event which occurs during operation of the device which can potentially have a haptic effect associated with it, which is then output to the user in the form of the haptic effect.

For instance, a haptic event may occur when a graphical vehicle the user is controlling experiences wind turbulence during game play, whereby an example haptic effect associated with that haptic event could be a vibration. Another example is that a haptic event may occur when a missile collides with the user's character in the game, whereby an example haptic effect associated with the haptic event is a jolt or pulse. Haptic events may not be associated with the game play, but nonetheless provides the user with important device information while the user is playing a game (e.g. receiving a text message, completion of a song download, battery level low, etc.).

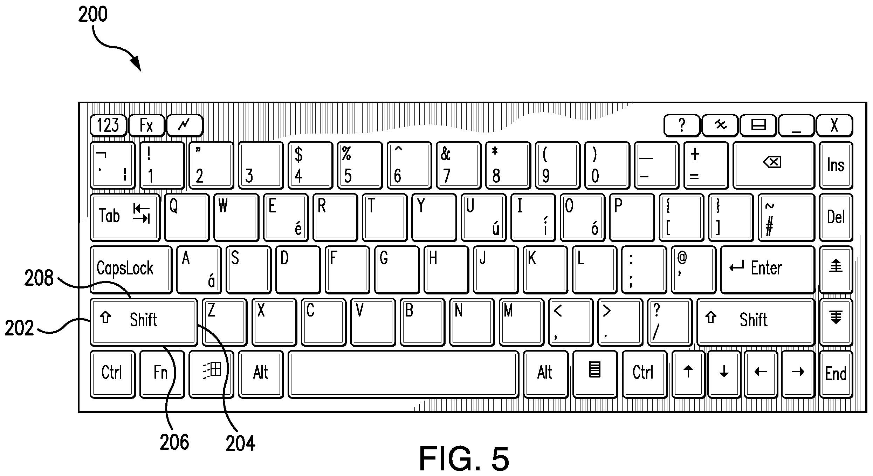

As also mentioned above, the interaction may correlate with a graphical object of a graphical environment which the user interacts with on a display screen. For instance, a haptic effect may be output by the system in response to an interaction where the user selects a designated area in a graphical environment, hereby referred to as a displayed haptic enabled area or just "haptic area." In an example, as shown in Figure 5, the boundaries of a displayed key of a keyboard may each be designated a haptic area. In Figure 5, the left boundary 202, right boundary 204, bottom boundary 206 and top boundary 208 of "shift" key may each be designated a haptic area, whereby the processor 104 instructs the actuators to output respective haptic effects when the sensor 110 indicates that the user's finger or stylus is moving over one or more of displayed boundary or boundaries. It is also contemplated that the area between the boundaries 202-208 within the "shift" key may be designated a haptic area. In some embodiments, haptic areas are designated when developing the software that is to be run on the device 100. In some embodiments, however, a user may be able to customize existing haptic areas or develop/designate new ones such as via a Preferences or Options menu.

Referring again to Figure 4, the present system and method utilizes multiple actuators to operate in successive order for a duration of time during which the interaction occurs. The staggered output of the multiple actuators are to increase the output bandwidth of the actuators at faster intervals and produce distinct, discrete haptic effects which are discernable to the user. In an embodiment, when a haptic event occurs (or a haptic area is selected), the processor 104 applies an input command signal with a designated voltage and current to the actuator 112 at a start time to cause the actuator 112 to accelerate to a maximum designated magnitude to output a corresponding haptic effect. Thereafter, the processor 104 terminates the input command signal at a stop time (such as based on programmed parameters of the hap tic effect which are stored in memory), upon which the actuator 112 decelerates from the maximum magnitude to a stop. The processor 104 then applies a designated voltage and current to the second actuator 114 at a respective start time to cause the actuator 114 to accelerate to a maximum designated magnitude to output a corresponding haptic effect. Upon reaching a stop time of the input command signal for the second actuator 114, the processor 104 terminates the pulse signal to the actuator 114 to allow the second actuator 114 to decelerate from its maximum magnitude to a stop. The processor 104 then again sends the input command signal to the first actuator 112 to begin outputting a haptic effect and so on.

In this embodiment, this process is repeated between the actuators 112, 114 to thus cause the actuators 112, 114 to alternately and successively output their respective haptic effects. In some embodiments, a particular actuator does not begin operating until the haptic effect output by the other actuator is at least at a magnitude and/or frequency that is not able to be discernibly felt by the user. However, in some embodiments, a particular actuator does not begin operating until the haptic effect output by the other actuator is at a zero magnitude and/or frequency.

In an embodiment, the scheduling of the start and stop times of the input command signals toward each of the actuators are predetermined and stored in the memory. This allows the processor to quickly retrieve the scheduling data and thus ease computational burdens when a haptic effect is to be output. The stored scheduling information may be in the form of a lookup table or other stored configuration in which the start and stop times for each actuator, in relation to the other actuators, are already established in which the processor 104 merely processes the stored information and accordingly activates the actuators based on the designated scheduling instructions. The scheduling instructions may be based on the type of actuators used (e.g. ERM, LRA, piezoelectric, etc.), the desired maximum and minimum magnitudes to be output by the actuators, voltages and frequencies at which the actuators will operate, type of haptic effect to be output (e.g. vibration, pop, click, etc.), and the overall operating characteristics of the actuators (e.g. heavy or light actuators, etc.).

In an embodiment, the particular operating characteristics of the actuator 112 will be known to the processor 104 in which the processor 104 is provided information on how long it takes the actuator 112 to accelerate from a stopped position to the desired magnitude and frequency based on the applied voltage and current. Further, the memory 106 may store information regarding how long it takes for the actuator 112 to decelerate from its maximum operating magnitude and frequency back to the stopped position. This is because, in one embodiment, the acceleration and deceleration time of the actuator 112, based on the type of current (i.e. AC vs. DC), is already known and is stored in the memory 106 as data or an instruction to be read by the processor and accordingly provided to the actuators. For example, in one embodiment, memory 106 comprises one or more actuator profiles associated with the actuators 112-116. In one embodiment, the actuator profiles comprise a plurality of parameters associated with the actuators, such as start-up time, stop time, minimum and maximum frequencies, maximum magnitudes, resonant frequencies, haptic effect types, axis(es) of operation, or power consumption. The processor 104 may then access the actuator profiles to determine which actuators, and how many actuators, to employ to generate one or more haptic effects.

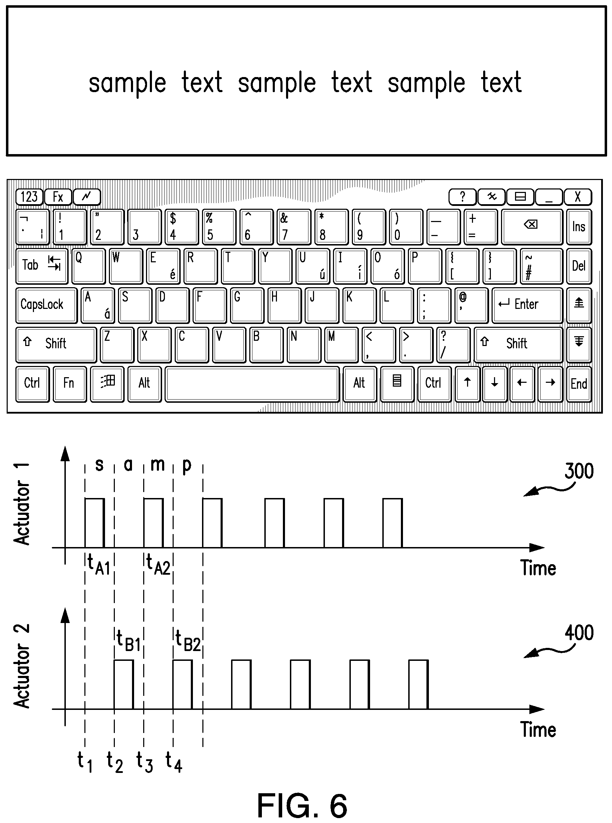

Figure 6 illustrates a graph illustrating the scheduled haptic effects output by two actuators in the system in accordance with an embodiment. As shown in Figure 6, the top graph 300 illustrates the pulsed haptic effect output by the first actuator 112 and the bottom graph 400 illustrates the pulsed haptic effect output by the second actuator 114 in which both graphs share a common time line. As shown in Figure 6, upon a haptic event occurring or haptic area being determined, the processor 104 sends its command signal to the actuator 112 at time t₁ in which the actuator 112 begins its operation. As shown in this embodiment, the input command signal is a square wave signal in which the processor 104 terminates its command signal at time t_{A1}, whereby time t_{A1} occurs before t₂. In this embodiment, the processor determines time t_{A1} based on actuator parameters stored in memory. For example, in one embodiment, the processor 104 determines a percentage of the stop time for an actuator 112, 114 to determine a minimum amount of time to wait after an actuator signal has been terminated before a new signal may be begun.

In one embodiment, the processor 104 determines an amount of time to wait after an actuator signal has been terminated before beginning a haptic effect of the same type. For example, in one embodiment, a device may comprise multiple different types of actuators, such as ERM actuators, DC motors, piezoelectric actuators, LRAs, etc. In such an embodiment, a processor may simultaneously actuate multiple actuators to output different types of effects, such as textures, vibrations, and torques. In such an embodiment, a processor may cause texture effects to be output irrespective of the status of vibrational effects or torsional effects. In such an embodiment, the processor 104 may determine that no wait time is required as a first haptic effect may be output substantially simultaneously as a second haptic effect without interfering with the two effects.

Around time t_{A1}, the actuator 112 decelerates to a magnitude such that no discernable haptic effect is felt by the user. In an embodiment, the actuator 112 decelerates to a zero magnitude around time t_{A1}. In some embodiments, different input command signals or actuator signals may be employed other than square waves. For example, actuators signals may be generated to accelerate or decelerate actuators to provide high-fidelity haptic effects such as is disclosed in U.S. Patent No. 7,639,232, filed November 30, 2005, entitled "Systems and Methods for Controlling a Resonant Device for Generating Vibrotactile Haptic Effects".

At time t₂ the processor 104 sends an input command signal to the actuator 114 in which the actuator 114 begins its operation and accelerates to a maximum magnitude. As shown in this embodiment, the command signal is a square wave signal in which the processor 104 terminates its command signal at time t_{B1}, whereby time t_{B1} occurs before t₃. Around time t_{B1}, the actuator 114 has sufficiently decelerated so that the processor 104 determines that the next actuator may be actuated. For example, in this embodiment, the processor 104 determines a portion of the stop time stored as a parameter for actuator 114 in memory. In an embodiment, the actuator 114 comes to or near a complete stop around time t_{B1}. In some embodiments, the processor 104 delays a fixed amount of time before actuating the next actuator 112. Thereafter, the processor 104 then instructs actuator 112 to begin operation at time t₃ and so on. This alternating pattern of output from multiple actuators can generate discrete haptic effects which are distinct and discernable when felt by the user, because the actuators are scheduled to operate in a staggered manner to provide the user with the feeling that the pulse from a prior haptic effect has sufficiently degenerated before a subsequent pulse is felt. Considering that in some embodiments a single actuator may not be able to achieve this result at frequencies around or greater than 10 Hz, the scheduling of multiple actuators is able to achieve such a result as such higher frequencies.

In another example, a QWERTY keyboard has keys approximately 6 millimeters wide in which the processor 104 instructs a single actuator to output a haptic effect upon the sensor 110 indicating that the user's finger (or stylus) is positioned on one boundary of a particular key. In another example, the user's finger runs across a series of keys (in particular, keys "z" to "m") at a rate of 7 keys per second. At the rate of 7 keys per second, the actuators are required to output haptic effects on the order of 1 key boundary every 70ms, which translates into approximately 14 key boundaries every second (or 71.4 milliseconds per boundary). A single actuator tasked to output a vibration for each of the haptic areas may generate a continuous, or nearly continuous, vibration, and thus the user may not feel any distinction between key boundaries. This is because the single actuator does not have the time to stop completely before the next pulse is already being output.

To ensure proper triggering of the haptic effects as well as clear, distinct and discernable haptic effects at the key boundaries, multiple actuators are employed to successively output the haptic effects to provide this tactile information. As the sensor 110 detects the user's input over the left boundary 202 of the "shift" key (see Figure 5), the processor 104 applies a first command signal to the actuator 112 As the sensor 110 detects the user's input over the right boundary 204 of the "shift" key, the processor 104 applies a second command signal to actuator 114. Accordingly, as the sensor 110 detects the user's input over the left boundary of key "z", the processor 104 applies a third command signal to actuator 112. This alternating pattern between the multiple actuators 112, 114 produces definitive and distinct haptic effects which are able to be distinguished by the user.

It should be noted that a single actuator (such as actuator 112) may be used to output multiple haptic effects when the amount of time between triggering haptic events and/or haptic areas is longer than the amount of time needed for the actuator to come to a complete stop or at least decelerate to a magnitude that is not able to be felt to the user. However, in some embodiments, the processor 104 activates multiple actuators (e.g. 2, 3, or more) successively when the amount of time between triggering haptic events and/or haptic areas is less than the amount of time needed for the actuator to come to a complete stop or at least decelerate to a magnitude that is not able to be felt to the user. The amount of time needed is based on the operating parameters and type of actuators used as well as the amount of current and voltage applied to the actuators.

The haptic effects that can be produced by the actuators vary depending on the current, voltage, frequency as well as start and stop times. Such haptic effects include, but are not limited to, vibrations, pulses, pops, clicks, damping characteristics, and varying textures. In an embodiment, the multiple actuators are utilized to generate different haptic effects for different applications. For example, the two actuators are configured to provide a vibration or pop upon the user's finger or stylus passing over the boundaries of a graphical object (e.g. keyboard keys), as discussed above. In addition, one or more actuators coupled to the touch sensitive component are activated when the user is detected within the boundaries to generate a texture-like haptic effect.

In an embodiment, the actuator is an eccentric rotating mass (ERM) actuator which is driven using a continuous DC voltage, whereby the ERM actuator is pulsed by the processor 104 to output the haptic effect and also achieve relatively short start and stop times at lower frequencies. However, when operating at higher frequencies (i.e. > 50Hz), the ERM actuator's response, especially the ability to accelerate and decelerate quickly enough to the desired magnitude, may be slower than needed to produce the distinct haptic effects described above. This is because, for a given constant DC driving voltage, the response of the actuator will be at a predetermined magnitude and frequency. In other words, increasing the magnitude of the DC driving voltage will proportionally result in an acceleration response with higher magnitude and higher acceleration. In the same vein, decreasing the magnitude of the DC driving voltage will proportionally result in a deceleration response with a lower magnitude and a lower deceleration.

For example, an ERM actuator may not be able to generate vibrations that are clear and distinct and having a magnitude of 0.4 Gpp at 120Hz upon the processor applying only a DC voltage to the actuator. Instead of driving the actuator only in DC mode, the processor 104 applies an AC signal to the actuator, whereby the actuator responds to the driving signal with an acceleration profile having the same frequency content as the input signal. This results in the ERM actuator having a considerable higher acceleration response than typical DC driven ERM actuators. This technique of overdriving the actuators in an AC (bipolar) mode dramatically improves the bandwidth of the actuator in the frequency domain. The actuator is thus able to generate different vibration effects at specific magnitudes and accelerations by superimposing the AC and DC input signals.

The main advantage of using multiple actuators in AC mode is that the overall system can achieve the principle of superposition. Applying two different input signals to the actuators, in which each input signal has different frequencies and magnitude parameters, will result in a vibration effect having those frequencies and proportional magnitudes. A single actuator is not capable of generating this superposition effect because it was not meant originally to have such a high bandwidth as was obtained when driving it in AC mode. This superposition principle is important when generating high fidelity vibration feedback (textures, pops and vibrations at the same time).

Although the actuators described above are ERM actuators, the actuators may also be a linear resonant actuator (LRA). The LRA actuator is a DC motor with a resonant mass-spring system in which the mass is actuated linearly back and forth in a one dimensional direction. The device is capable of generating a high acceleration response at a specific frequency, for instance 175Hz. However, at other frequencies the acceleration is close to 0 for the same input magnitude. However, if the magnitude of the input signal is increased in those areas where the response is weak, the resulting acceleration is strong enough to provide a good vibration effect at those specific frequencies and with a magnitude dependent on the magnitude of the driving signal. In some embodiments, other types of actuators may be employed. For example, smart gel actuators may be employed to provide textures or physical boundaries on the touch screen that correspond to objects shown by the touch screen, such as keys on a keyboard.

As discussed previously, some embodiments of the present invention may comprise a plurality of different types of actuators. For example, in one embodiment, actuators 112-116 may comprise ERM or LRA actuators and piezoelectric actuators. As noted previously, piezoelectric actuators may provide different types of haptic effects than ERM or LRA actuators. For example, piezoelectric actuators may provide low magnitude effects, but may have wide frequency ranges in which effects may be output. In some embodiments, piezoelectric actuators may be well-suited to applying haptic effects to a touch screen.

In one embodiment, memory 106 may comprise parameters associated with each of the actuators 112-116. In such an embodiment, memory 106 comprises parametric information about each of the actuators, such as minimum and maximum operational frequencies, minimum and maximum operational magnitudes, start-up and stop times, and axis(es) of operation. For example, in this embodiment, the ERM actuators have minimum and maximum operational frequencies of approximately 100 and 300 Hz respectively, while the piezoelectric actuators have minimum and maximum operational frequencies from 100 to 25,000 Hz.

In this embodiment, the processor 104 determines a vibrational haptic effect is to be output at approximately 200Hz and generates a first actuator signal configured to cause a vibration at 200 Hz. Based at least in part on the actuator parameter information, the processor selects one of the ERM actuators. The processor then transmits the first actuator signal to the selected ERM actuator. The processor also determines that a texture haptic effect is to be output at approximately 25,000 Hz and generates a second actuator signal configured to cause a vibration at 25,000 Hz. Based at least in part on the actuator parameter information, the processor selects one of the piezoelectric actuators. The processor then transmits the second actuator signal to the selected piezoelectric actuator. In this embodiment, the two haptic effects may be output at approximately the same time. Thus, the actuator sequencing described above need not be performed. However, if multiple haptic effects are to be output in rapid succession, the processor 104 may output the first actuator signal alternately to the two ERM actuators according to embodiments of the present invention.

While the prior embodiment disclosed a combination of ERM and piezoelectric actuators, other combinations of actuators may be used. For example, in one embodiment a combination of ERM and LRA actuators may be used. For example, multiple ERM or LRA actuators of different sizes may be included to provide a range of vibrational frequencies, which may be actuated individually or simultaneously. In such an embodiment, memory 106 comprises parameters associated with each actuator, including minimum and maximum operational frequencies, minimum and maximum operational magnitudes, start-up and stop times, and axis(es) of operation. The parameters also further comprise a resonant frequency associated with each actuator, if the respective actuator has such a characteristic. Thus, the processor 104 may select a suitable actuator or actuators to generate the desired haptic effects.

As discussed with respect to the embodiment with a combination of piezoelectric and ERM actuators, the processor 104 selects the appropriate actuator or actuators based upon the haptic effect to be output and the parameters describing each of the actuators. In some embodiments, the processor 104 may further select an actuator based on the operational status of an actuator, such as whether the actuator is in use or is still stopping.

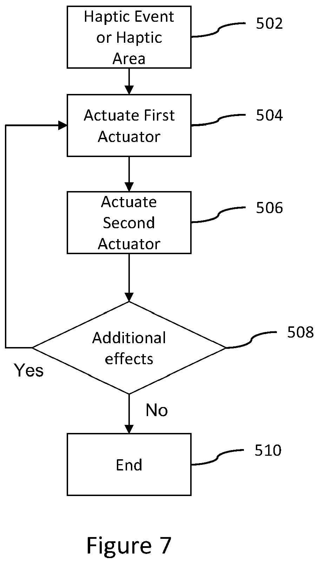

Referring now to Figure 7, Figure 7 illustrates a flow chart directed to the method of outputting haptic effects to increase the haptic bandwidth of the actuators in an electronic device. In particular, in 502 the processor is provided with information as to whether a haptic event occurs (e.g. a collision in a video game) and/or a haptic area has been selected (e.g. user's finger or stylus moving over a boundary of a displayed key). This information may be provided from the sensor 110 and/or from the software running by the processor or a separate host computer. Upon the processor 104 being notified that a haptic effect is to be output, the processor 104 applies an input command signal to the first actuator at predetermined start and stop times, as in 504. Thereafter, the processor applies an input command signal to the second actuator at predetermined start and stop times, as in 506, whereby the start time of the second actuator does not occur until after the stop time of the input command signal to the first actuator. In some embodiments, this process repeats between the first and second actuators 112, 114 for a predetermined duration of time, as in 506.

The processor 104 confirms that the haptic event and/or haptic area is still activated, or in other words that the interaction is still occurring, when the predetermined duration of time has expired, as in 508. If the interaction which is causing the haptic effect is still occurring when the duration expires, the processor 104 continues to alternate between the actuators, as in 504. On the other hand, if the interaction is over when the duration ends, the processor 104 terminates the input command signal to the actuators, 510. It is contemplated that the processor 104 is informed if the interaction ceases prior to the expiration of the duration, whereby the processor 104 will prematurely terminate the input command signal to the actuators to end the outputted haptic effects.

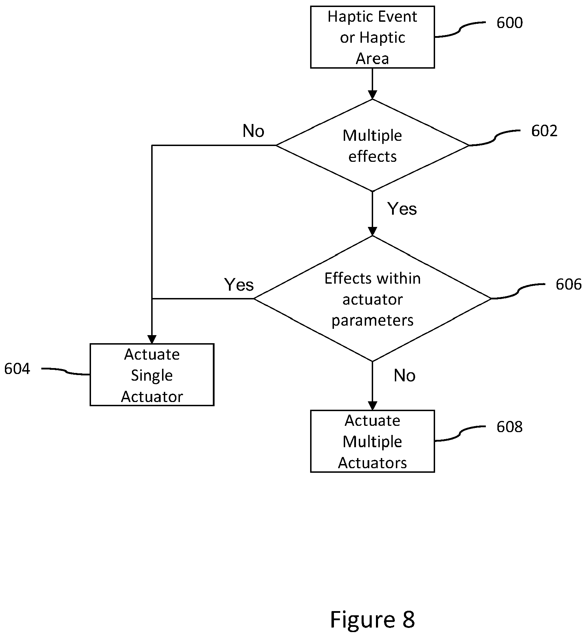

Referring now to Figure 8, Figure 8 illustrates another flow chart directed to the method of outputting haptic effects to increase the haptic bandwidth of the actuators in an electronic device. It should be noted that the methods in Figures 7 and 8 can be combined completely or partially and the methods are not mutually exclusive. As shown in Figure 8, the processor determines whether the two or more distinct haptic effects are to be output as a result of the action requiring the haptic effect, as shown as 602. If it is determined that less than two distinct haptic effects are to be produced, the processor 104 instructs only a single actuator to output the haptic effect, as in 604 in Figure 8. Again, this determination may be based on the sensor information and/or software instruction as well as the assigned haptic effect for the particular action. For example, a collision may occur on the display in which the designated haptic effect for the collision is a single vibration, whereby the processor 104 would instruct only one actuator to output the vibration. It should be noted that 604 is optional as the processor may alternatively choose to have more than one actuator simultaneously, or in sequence, output the haptic effect.

However, if it is determined that multiple distinct haptic effects are to be produced based on the haptic event/haptic area, it is determined whether the multiple actuators would be operating at a frequency and magnitude such that haptic effects would not be distinct and individually discernible to the user if only a single actuator were employed, as shown as 606 in Figure 8, or whether the two (or more) haptic effects are of different types such that different types of actuators should be used (e.g. ERM and piezoelectric). For example, based on the frequency and magnitude of the input command signal, if an ERM actuator would not be able to decelerate to a negligible magnitude, or for a sufficient percentage of its stop time as stored in an actuator profile within memory 114, before it is required to accelerate again to the maximum magnitude, the resulting haptic effects may feel mushy and indistinct, as described above. Accordingly, in such a case, the processor 104 would then send input command signals to multiple actuators, as in 608, whereby the command signals would selectively activate the actuators in an alternating manner, such as according to the embodiment shown in Figure 7, to output clear, distinct, and discernible haptic effects from the actuators. In contrast, if it is determined that the multiple haptic effects could be output by a single actuator based on the parameters describing the actuator and characteristics of the haptic effects, the processor 104 generates input command signals based on the haptic effects and applies the input command signal to only one actuator to output the haptic effect. In some embodiments, the processor 104 makes these determinations in real-time. However, in some embodiments, each of the assigned haptic effects, along with frequency, magnitude, start and stop time data, other parameters of the actuators and instructions on whether single or multiple actuators are to be output are stored in the memory 106 such that the processor 104 can easily processes the instructions and accordingly instruct which actuators to activate. Again, this determination may be based on the sensor information, actuator parameters stored in memory 106, and/or software instruction as well as the assigned haptic effect for the particular action. For example, a collision may occur on the display in which the designated haptic effect for the collision is a single vibration, whereby the processor 104 would instruct only one actuator to output the vibration.

In another embodiment, the processor 104 determines that multiple haptic effects are to be output by multiple actuators based on the type of haptic effects to be output. For example, at step 600, the processor 104 determines that a vibrational haptic effect is to be output based on a user contacting the edge of a key on a virtual keyboard and that a textured haptic effect should be output to simulate the feel of a keyboard. In such an embodiment, at step 602, the processor 104 determines that multiple haptic effects are to be output and the method proceeds to step 606.

In step 606, the processor determines which effects are to be output by which actuators by determining which actuators are capable of outputting the haptic effects. For example, in one embodiment, a texture effect may be output by a outputting a vibration at a frequency of greater than approximately 20kHz and adjusting the magnitude of the vibration, such as by setting the magnitude of vibration as a percentage of the maximum magnitude or by modulating the magnitude according to a second signal, such as a sine wave or other periodic or non-periodic waveform. For example, in one embodiment, the magnitude of the vibration may be set to 0% outside of a haptic region and to 50% or 100% for contact within the haptic region. In one embodiment, a second or modulating frequency may have a frequency of 10Hz such that the magnitude of the 20kHz vibration varies from 0 to 100% at a rate of 10Hz. In some embodiments, higher modulating frequencies may be used, such as 100Hz, 500Hz or 1000Hz, or other suitable frequencies. The processor 104 analyzes parameters stored in memory 106 that are associated with each actuator. Based on the parameters, the processor 104 determines that the ERM actuators are not capable of producing such effects. Therefore the processor 104 determines that a piezoelectric actuator should be selected to output the texture effect.

Similarly, a vibration to indicate the edge of a key on a virtual keyboard may have a high-magnitude vibration frequency between approximately 100-300Hz, such as 200Hz. In such a case, the processor 104 selects an ERM actuator to output the haptic effects. The processor 104 may further determine that multiple vibrational effects are to be output and that multiple ERM actuators should be employed, such as by employing techniques described above. After determining which actuators are associated with each haptic effect, the method proceeds to step 608.

In step 608, the processor generates a first actuator signal configured to cause a vibration at a frequency of greater than approximately 20kHz to generate the texture haptic effect. The processor also generates a second actuator signal configured to cause a vibration at 200Hz. The processor then transmits the first actuator signal to the piezoelectric actuator and transmits the second actuator signal to the ERM actuator. In an embodiment, the processor 104 may alternately transmit the second actuator signal to multiple ERM actuators as described above.

While the methods and systems herein are described in terms of software executing on various machines, the methods and systems may also be implemented as specifically-configured hardware, such a field-programmable gate array (FPGA) specifically to execute the various methods. For example, referring again to Figures 1 and 2, embodiments can be implemented in digital electronic circuitry, or in computer hardware, firmware, software, or in combination of them. In one embodiment, a computer may comprise a processor or processors. The processor comprises a computer-readable medium, such as a random access memory (RAM) coupled to the processor. The processor executes computer-executable program instructions stored in memory, such as executing one or more computer programs for editing an image. Such processors may comprise a microprocessor, a digital signal processor (DSP), an application-specific integrated circuit (ASIC), field programmable gate arrays (FPGAs), and state machines. Such processors may further comprise programmable electronic devices such as PLCs, programmable interrupt controllers (PICs), programmable logic devices (PLDs), programmable read-only memories (PROMs), electronically programmable read-only memories (EPROMs or EEPROMs), or other similar devices.

Such processors may comprise, or may be in communication with, media, for example computer-readable media, that may store instructions that, when executed by the processor, can cause the processor to perform the steps described herein as carried out, or assisted, by a processor. Embodiments of computer-readable media may comprise, but are not limited to, an electronic, optical, magnetic, or other storage device capable of providing a processor, such as the processor in a web server, with computer-readable instructions. Other examples of media comprise, but are not limited to, a floppy disk, CD-ROM, magnetic disk, memory chip, ROM, RAM, ASIC, configured processor, all optical media, all magnetic tape or other magnetic media, or any other medium from which a computer processor can read. The processor, and the processing, described may be in one or more structures, and may be dispersed through one or more structures. The processor may comprise code for carrying out one or more of the methods (or parts of methods) described herein.

The foregoing description of some embodiments of the invention has been presented only for the purpose of illustration and description and is not intended to be exhaustive or to limit the invention to the precise forms disclosed.

Reference herein to "one embodiment" or "an embodiment" means that a particular feature, structure, operation, or other characteristic described in connection with the embodiment may be included in at least one implementation of the invention. The invention is not restricted to the particular embodiments described as such. The appearance of the phrase "in one embodiment" or "in an embodiment" in various places in the specification does not necessarily refer to the same embodiment. Any particular feature, structure, operation, or other characteristic described in this specification in relation to "one embodiment" may be combined with other features, structures, operations, or other characteristics described in respect of any other embodiment.

## Claims

1. An apparatus comprising:
a first actuator (112);
a second actuator (114);
a processor (104) coupled to the first (112) and second actuators (114), the processor configured to apply a first command signal to the first actuator to output a first haptic effect from a first start time to a first stop time, the processor (104) configured to apply a second command signal to the second actuator to output a second haptic effect from a second start time to a second stop time;
a computer-readable medium (106) configured to store first and second actuator information, the first actuator information comprising at least one parameter describing a performance characteristic of the first actuator (112), and the second actuator information comprising at least one parameter describing a performance characteristic of the second actuator (114); and
wherein the processor (104) is configured to:
receive a command;
determine a haptic effect based on the command;
select one or both of the first actuator (112) and the second actuator (114) based at least in part on the haptic effect, and analysis of the first actuator information and of the second actuator information, and
if the first actuator (112) is selected, generate the first command signal, and
if the second actuator (114) is selected, generate the second command signal.

2. The apparatus of claim 1, wherein the at least one parameter describing a performance characteristic of the first actuator and the at least one parameter describing a performance characteristic of the second actuator include, where applicable: start-up and stop times, axis(es) of operation, minimum and maximum operational magnitudes and frequencies, resonant frequencies, acceleration and deceleration times.

3. The apparatus of claim 1 or 2, wherein the first haptic effect and the second haptic effect are vibrations.

4. The apparatus of any preceding claim, wherein the first actuator (112) is of a different type than the second actuator (114).

5. The apparatus of any preceding claim, wherein the first (112) and second actuators (101) are selected from a group comprising ERM, DC motor, piezoelectric, LRA and smart gel actuators.

6. The apparatus of any preceding claim, further comprising:
a touch sensitive component (108) coupled to the processor (104), the touch sensitive component (108) configured to display a graphical object thereon; and
a sensor (110) coupled to the touch sensitive component (108) and the processor (104), the sensor (110) configured to detect a position of a user input on the touch sensitive component (108), wherein the processor (104) is configured to activate the first and second actuators (112, 114) upon the sensor (110) indicating the user's input on a haptic enabled area in the graphical object.

7. The apparatus of any preceding claim, wherein the processor (104) is configured to activate the first and second actuators (112, 114) upon a software program indicating a haptic event has occurred.

8. The apparatus of any preceding claim, further comprising a third actuator (116) coupled to the processor (104), wherein the third actuator (116) outputs a third haptic effect different than the first and second haptic effects.

9. The apparatus of claim 8, wherein the third actuator is coupled to a touch sensitive component (108), wherein the third haptic effect is a high-frequency vibration applied to the touch sensitive component (108) to provide a texture effect or to reduce a friction force between the touch sensitive component (108) and a user's input.

10. The apparatus of claim 1, wherein the processor (104) determines multiple haptic effects and further determines whether or not a single actuator would be operating at a frequency and magnitude such that the haptic effects would be distinct and individually discernible to the user if only a single actuator were employed and:
if so, to generate either the first command signal or the second command signal only;
but if not, to generate the first command signal and the second command signal to selectively activate the actuators in an alternating manner.

11. The apparatus of claim 1 and 4, wherein the processor (104) determines that two or more haptic effects are of different types such that different types of actuators should be used substantially simultaneously.

12. A method comprising:
applying a first command signal from a processor (104) to a first actuator (112), the first command signal being configured to cause the first actuator (112) to output a first haptic effect from a first start time to a first stop time;
applying a second command signal from the processor (104) to a second actuator (114), the second command signal being configured to cause the second actuator (114) to output a second haptic effect from a second start time to a second stop time;
storing first and second actuator information in a computer-readable medium (106), the first actuator information comprising at least one parameter describing a performance characteristic of the first actuator (112), and the second actuator information comprising at least one parameter describing a performance characteristic of the second actuator (114);
determining a haptic effect based on a command received by the processor (104);
wherein the processor (104) selects one or both of the first actuator (112) and the second actuator (114) based at least in part on the haptic effect, and analysis of the first actuator information and of the second actuator information, and
if the first actuator (112) is selected, generating the first command signal and
if the second actuator (114) is selected, generating the second command signal.

13. The method of claim 12, further comprising:
displaying a graphical environment via a touch sensitive component (108) coupled to the processor (104);
detecting a selection of a haptic area in the graphical environment; and
sending the command signal corresponding to the selection of the haptic area to the processor (104).

14. The method of claim 12, further comprising outputting a third haptic effect via a third actuator (116) upon receiving a corresponding command signal from the processor (104), wherein the third haptic effect is different than the first and second haptic effects.

15. A computer readable medium comprising computer code executable to implement the method of any of claims 12-14.

## Patentansprüche

1. Eine Vorrichtung umfassend:
einen ersten Aktuator (112);
einen zweiten Aktuator (114);
einen Prozessor (104), der mit dem ersten (112) und dem zweiten Aktuator (114) gekoppelt ist, wobei der Prozessor konfiguriert ist, um ein erstes Befehlssignal an den ersten Aktuator anzulegen, um einen ersten haptischen Effekt von einer ersten Startzeit bis zu einer ersten Stoppzeit auszugeben, wobei der Prozessor (104) konfiguriert ist, um ein zweites Befehlssignal an den zweiten Aktuator anzulegen, um einen zweiten haptischen Effekt von einer zweiten Startzeit bis zu einer zweiten Stoppzeit auszugeben;
ein computerlesbares Medium (106), das zum Speichern der ersten und zweiten Aktuatorinformation konfiguriert ist, wobei die erste Aktuatorinformation mindestens einen Parameter umfasst, der ein Leistungsmerkmal des ersten Aktuators (112) beschreibt, und die zweite Aktuatorinformation mindestens einen Parameter umfasst, der ein Leistungsmerkmal des zweiten Aktuators (114) beschreibt; und
wobei der Prozessor (104) konfiguriert ist, um
einen Befehl zu empfangen;
einen haptischen Effekt basierend auf dem Befehl zu bestimmen;
einen oder beide von dem ersten Aktuator (112) und dem zweiten Aktuator (114) zumindest teilweise basierend auf dem haptischen Effekt auszuwählen und die erste Aktuatorinformation und die zweite Aktuatorinformation zu analysieren, und
wenn der erste Aktuator (112) ausgewählt wird, ein erstes Befehlssignal zu erzeugen, und
wenn der zweite Aktuator (114) ausgewählt wird, ein zweites Befehlssignal zu erzeugen.

2. Die Vorrichtung gemäß Anspruch 1, wobei der mindestens eine Parameter, der ein Leistungsmerkmal des ersten Aktuators beschreibt, und der mindestens eine Parameter, der ein Leistungsmerkmal des zweiten Aktuators beschreibt, folgendes einschließt:
gegebenenfalls: Anlauf- und Stoppzeiten, Betriebsachse(n), minimale und maximale Betriebsgrößen und -frequenzen, Resonanzfrequenzen, Beschleunigungs- und Verzögerungszeiten.

3. Die Vorrichtung gemäß Anspruch 1 oder 2, wobei der erste haptische Effekt und der zweite haptische Effekt Schwingungen sind.

4. Die Vorrichtung gemäß irgendeinem vorhergehenden Anspruch, wobei der erste Aktuator (112) von einer anderen Bauart als der zweite Aktuator (114) ist.

5. Die Vorrichtung gemäß irgendeinem vorhergehenden Anspruch, wobei der erste Aktuator (112) und der zweite Aktuator (114) ausgewählt sind aus der Gruppe umfassend ERM-(exzentrische rotierende Masse)-, Gleichstrom-, piezoelektrische, LRA-(lineare Resonanzaktuatoren) und Smart-Gel-Aktuatoren umfasst.

6. Die Vorrichtung gemäß irgendeinem vorhergehenden Anspruch, ferner umfassend:
eine berührungsempfindliche Komponente (108), die mit dem Prozessor (104) gekoppelt ist, wobei die berührungsempfindliche Komponente (108) konfiguriert ist, um ein grafisches Objekt darauf anzuzeigen; und
einen Sensor (110), der mit der berührungsempfindlichen Komponente (108) und dem Prozessor (104) gekoppelt ist, wobei der Sensor (110) konfiguriert ist, um eine Position einer Benutzereingabe auf der berührungsempfindlichen Komponente (108) zu erfassen, wobei der Prozessor (104) konfiguriert ist, um den ersten und zweiten Aktuator (112, 114) auf dem Sensor (110) zu aktivieren, der die Benutzereingabe auf einem haptisch aktivierten Bereich im grafischen Objekt anzeigt.

7. Die Vorrichtung gemäß irgendeinem vorhergehenden Anspruch, wobei der Prozessor (104) konfiguriert ist, um den ersten und den zweiten Aktuator (112, 114) mit einem Softwareprogramm zu aktivieren, das anzeigt, dass ein haptisches Ereignis aufgetreten ist.

8. Die Vorrichtung gemäß irgendeinem vorhergehenden Anspruch, ferner umfassend einen dritten Aktuator (116), der mit dem Prozessor (104) gekoppelt ist, wobei der dritte Aktuator (116) einen dritten haptischen Effekt ausgibt, der sich von dem ersten und dem zweiten haptischen Effekt unterscheidet.

9. Die Vorrichtung gemäß Anspruch 8, wobei der dritte Aktuator mit einer berührungsempfindlichen Komponente (108) gekoppelt ist, wobei der dritte haptische Effekt eine hochfrequente Vibration ist, die auf die berührungsempfindliche Komponente (108) angewendet wird, um einen Textureffekt bereitzustellen oder eine Reibungskraft zwischen der berührungsempfindlichen Komponente (108) und einer Benutzereingabe zu verringern.

10. Die Vorrichtung gemäß Anspruch 1, wobei der Prozessor (104) multiple haptische Effekte bestimmt und weiterhin bestimmt, ob oder ob nicht ein einzelner Aktuator bei einer Frequenz oder mit einer Stärke arbeitet, so dass die haptischen Effekte deutlich und für den Benutzer individuell wahrnehmbar wären, wenn nur ein einziger Aktuator eingesetzt würde, und:
wenn ja, um entweder nur das erste oder nur das zweite Steuersignal zu erzeugen;
wenn nicht, um das erste Steuersignal und das zweite Steuersignal zu erzeugen, um die Aktuatoren selektiv abwechselnd zu aktivieren.

11. Die Vorrichtung gemäß Anspruch 1 und 4, wobei der Prozessor (104) bestimmt, dass zwei oder mehrere haptische Effekte unterschiedlich sind so dass unterschiedliche Typen von Aktuatoren im Wesentlichen gleichzeitig benutzt werden sollen.

12. Ein Verfahren umfassend:
Anlegen eines ersten Befehlssignals von einem Prozessor (104) an einen ersten Aktuator (112), wobei das erste Befehlssignal konfiguriert ist, um den ersten Aktuator (112) zu veranlassen, einen ersten haptischen Effekt von einem ersten Startzeitpunkt bis zu einem ersten Stoppzeitpunkt auszugeben;
Anlegen eines zweiten Befehlssignals von dem Prozessor (104) an einen zweiten Aktuator (114), wobei das zweite Befehlssignal konfiguriert ist, um den zweiten Aktuator (114) zu veranlassen, einen zweiten haptischen Effekt von einem zweiten Startzeitpunkt bis zu einem zweiten Stoppzeitpunkt auszugeben;
Speichern von ersten und zweiten Aktuatorinformationen in einem computerlesbaren Medium (106), wobei die erste Aktuatorinformation mindestens einen Parameter umfasst, der ein Leistungsmerkmal des ersten Aktuators (112) beschreibt, und die zweite Aktuatorinformation mindestens einen Parameter umfasst, der ein Leistungsmerkmal des zweiten Aktuators (114) beschreibt;
Bestimmen eines haptischen Effekts basierend auf dem Befehl, der durch den Prozessor (104) empfangen wurde;
wobei der Prozessor (104) einen oder beide von dem ersten Aktuator (112) und dem zweiten Aktuator (114) zumindest teilweise basierend auf dem haptischen Effekt auswählt und die erste Aktuatorinformation und die zweite Aktuatorinformation analysiert, und
wenn der erste Aktuator (112) ausgewählt wird, ein erstes Befehlssignal erzeugt, und
wenn der zweite Aktuator (114) ausgewählt wird, ein zweites Befehlssignal erzeugt.

13. Das Verfahren gemäß Anspruch 12, weiterhin umfassend:
Anzeigen einer grafischen Umgebung über eine berührungsempfindliche Komponente (108), die mit dem Prozessor (104) gekoppelt ist;
Erfassen einer Auswahl eines haptischen Bereichs in der grafischen Umgebung; und
Senden des Befehlssignals entsprechend der Auswahl des haptischen Bereichs an den Prozessor (104).

14. Das Verfahren gemäß Anspruch 12, weiterhin umfassend das Ausgeben eines dritten haptischen Effekts über einen dritten Aktuator (116) beim Empfangen eines entsprechenden Befehlssignals von dem Prozessor (104), wobei sich der dritte haptische Effekt von dem ersten und dem zweiten haptischen Effekt unterscheidet.

15. Ein computerlesbares Medium enthaltend einen Computercode, der zur Umsetzung des Verfahrens gemäß irgendeinem der Ansprüche 12 bis 14 ausführbar ist.

## Revendications

1. Appareil comprenant :
un premier actionneur (112) ;
un deuxième actionneur (114) ;
un processeur (104) couplé aux premier (112) et deuxième actionneurs (114), le processeur configuré pour appliquer un premier signal de commande au premier actionneur pour délivrer en sortie un premier effet haptique d'un premier instant de départ à un premier instant d'arrêt, le processeur (104) configuré pour appliquer un second signal de commande au deuxième actionneur pour délivrer en sortie un deuxième effet haptique d'un second instant de départ à un second instant d'arrêt ;
un support lisible par ordinateur (106) configuré pour stocker des premières et secondes informations d'actionneur, les premières informations d'actionneur comprenant au moins un paramètre décrivant une caractéristique de performance du premier actionneur (112), et les secondes informations d'actionneur comprenant au moins un paramètre décrivant une caractéristique de performance du deuxième actionneur (114) ; et
dans lequel le processeur (104) est configuré pour :
recevoir une commande ;
déterminer un effet haptique sur la base de la commande ;
sélectionner l'un ou les deux du premier actionneur (112) et du deuxième actionneur (114) sur la base au moins en partie de l'effet haptique, et de l'analyse des premières informations d'actionneur et des secondes informations d'actionneur, et
si le premier actionneur (112) est sélectionné, générer le premier signal de commande, et
si le deuxième actionneur (114) est sélectionné, générer le second signal de commande.

2. Appareil selon la revendication 1, dans lequel le au moins un paramètre décrivant une caractéristique de performance du premier actionneur et le au moins un paramètre décrivant une caractéristique de performance du deuxième actionneur incluent, le cas échéant : des instants de départ et d'arrêt, un (des) axe(s) de fonctionnement, des magnitudes et fréquences de fonctionnement minimales et maximales, des fréquences de résonance, des temps d'accélération et de décélération.

3. Appareil selon la revendication 1 ou 2, dans lequel le premier effet haptique et le deuxième effet haptique sont des vibrations.

4. Appareil selon une quelconque revendication précédente, dans lequel le premier actionneur (112) est d'un type différent du deuxième actionneur (114).

5. Appareil selon une quelconque revendication précédente, dans lequel les premier (112) et deuxième (101) actionneurs sont sélectionnés dans un groupe comprenant un actionneur RME, un moteur CC, un actionneur piézoélectrique, ARL et à gel intelligent.

6. Appareil selon une quelconque revendication précédente, comprenant en outre :
un composant tactile (108) couplé au processeur (104), le composant tactile (108) configuré pour afficher un objet graphique sur celui-ci ; et
un capteur (110) couplé au composant tactile (108) et au processeur (104), le capteur (110) configuré pour détecter une position d'une entrée d'utilisateur sur le composant tactile (108), dans lequel le processeur (104) est configuré pour activer les premier et deuxième actionneurs (112, 114) lorsque le capteur (110) indique l'entrée d'utilisateur sur une zone à activation haptique dans l'objet graphique.

7. Appareil selon une quelconque revendication précédente, dans lequel le processeur (104) est configuré pour activer les premier et deuxième actionneurs (112, 114) lorsqu'un programme logiciel indiquant un événement haptique s'est produit.

8. Appareil selon une quelconque revendication précédente, comprenant en outre un troisième actionneur (116) couplé au processeur (104), dans lequel le troisième actionneur (116) délivre en sortie un troisième effet haptique différent des premier et deuxième effets haptiques.

9. Appareil selon la revendication 8, dans lequel le troisième actionneur est couplé à un composant tactile (108), dans lequel le troisième effet haptique est une vibration haute fréquence appliquée au composant tactile (108) pour fournir un effet de texture ou pour réduire une force de frottement entre le composant tactile (108) et une entrée d'utilisateur.

10. Appareil selon la revendication 1, dans lequel le processeur (104) détermine de multiples effets haptiques et détermine en outre si un actionneur unique fonctionne ou non à une fréquence et une magnitude telles que les effets haptiques sont distincts et individuellement discernables par l'utilisateur si seulement un actionneur unique est employé et :
dans l'affirmative, pour générer soit le premier signal de commande soit le second signal de commande seulement ;
mais dans la négative, pour générer le premier signal de commande et le second signal de commande pour activer sélectivement les actionneurs d'une manière alternée.

11. Appareil selon la revendication 1 et 4, dans lequel le processeur (104) détermine que deux effets haptiques ou plus sont de types différents de telle manière que différents types d'actionneurs doivent être utilisés sensiblement simultanément.

12. Procédé comprenant les étapes :
d'application d'un premier signal de commande d'un processeur (104) à un premier actionneur (112), le premier signal de commande étant configuré pour amener le premier actionneur (112) à délivrer en sortie un premier effet haptique d'un premier instant de départ à un premier instant d'arrêt ;
d'application d'un second signal de commande du processeur (104) à un deuxième actionneur (114), le second signal de commande étant configuré pour amener le deuxième actionneur (114) à délivrer en sortie un deuxième effet haptique d'un second instant de départ à un second instant d'arrêt ;
de stockage de premières et secondes informations d'actionneur dans un support lisible par ordinateur (106), les premières informations d'actionneur comprenant au moins un paramètre décrivant une caractéristique de performance du premier actionneur (112), et les secondes informations d'actionneur comprenant au moins un paramètre décrivant une caractéristique de performance du deuxième actionneur (114) ;
de détermination d'un effet haptique sur la base d'une commande reçue par le processeur (104) ;
dans lequel le processeur (104) sélectionne l'un ou les deux du premier actionneur (112) et du deuxième actionneur (114) sur la base au moins en partie de l'effet haptique, et de l'analyse des premières informations d'actionneur et des secondes informations d'actionneur, et
si le premier actionneur (112) est sélectionné, de génération du premier signal de commande et
si le deuxième actionneur (114) est sélectionné, de génération du second signal de commande.

13. Procédé selon la revendication 12, comprenant en outre les étapes :
d'affichage d'un environnement graphique via un composant tactile (108) couplé au processeur (104) ;
de détection d'une sélection d'une zone haptique dans l'environnement graphique ; et
d'envoi du signal de commande correspondant à la sélection de la zone haptique au processeur (104).

14. Procédé selon la revendication 12, comprenant en outre l'étape de délivrance en sortie d'un troisième effet haptique via un troisième actionneur (116) lors d'une réception d'un signal de commande correspondant à partir du processeur (104), dans lequel le troisième effet haptique est différent des premier et deuxième effets haptiques.

15. Support lisible par ordinateur comprenant un code informatique exécutable pour mettre en œuvre le procédé selon l'une quelconque des revendications 12 à 14.
